# EUROPEAN PATENT APPLICATION

(11) **EP 4 362 068 A1**
(43) Date of publication of application: **01.05.2024**
(21) Application number: 22203463.9
(22) Date of filing: 25.10.2022
(51) Int. Cl.: H01L 21/336, H01L 29/78, H01L 29/41

(54) **TRANSISTOR DEVICE AND METHOD OF FABRICATING CONTACTS TO A SEMICONDUCTOR SUBSTRATE**

(71) Applicant: Infineon Technologies Austria AG, 9500 Villach (AT)
(72) Inventor: ROESCH, Maximilian, 9524 St. Magdalen (AT); LEE, Seung Hwan, 9020 Klagenfurt (AT)
(74) Representative: JENSEN & SON

(57) **Abstract**

In an embodiment, a transistor device is provided that comprises a semiconductor substrate having a first major surface and a second major surface opposing the first major surface, a drain region of a first conductivity type formed at the second surface, a drift region of the first conductivity formed on the drain region, a body region of a second conductivity type that opposes the first conductivity type formed on the drift region and a source region of a first conductivity type formed on and/or in the body region. A trench is arranged in the first surface comprising a base and sidewalls. Aa gate electrode arranged in the trench and electrically insulated from the semiconductor substate by a gate insulating layer and a field plate arranged in the trench under the gate electrode and electrically insulated from the gate electrode and the semiconductor substrate by a field insulator. The base of the trench is positioned at a depth d form the first major surface, wherein 250 nm ≤ d ≤ 800 nm.

## Description

### BACKGROUND

To date, transistors used in power electronic applications have typically been fabricated with silicon (Si) semiconductor materials. Common transistor devices for power applications include Si CooIMOS^{®}, Si Power MOSFETs, and Si Insulated Gate Bipolar Transistors (IGBTs).

A transistor device for power applications may be based on the charge compensation principle. In some designs, the transistor device has a superjunction structure for charge compensation. A superjunction structure includes a drift region with a plurality of regions of a first doping type (conductivity type) and a plurality of regions of a second doping type (conductivity type) complementary or opposite to the first doping type.

In other designs, the transistor device includes an active cell field including a plurality of trenches, each including a field plate for charge compensation. The field plate in the trenches is electrically insulated from the substrate by a field oxide. The gate electrode may be positioned in the trench above the field plate or may be arranged in a separate gate trench. US 2013/0221431 A1 discloses a method for manufacturing a semiconductor device with a field plate in a lower portion of the trench and a gate electrode arranged in the upper portion of the trench.

It is desirable to provide transistor devices which are reliable and have a high efficiency.

### SUMMARY

In an embodiment, a transistor device is provided. The transistor device comprises a semiconductor substrate having a first major surface and a second major surface opposing the first major surface, a drain region of a first conductivity type formed at the second surface, a drift region of the first conductivity formed on the drain region, a body region of a second conductivity type that opposes the first conductivity type formed in the drift region and a source region of a first conductivity type formed on and/or in the body region. A trench is arranged in the first major surface that comprises a base and sidewalls. A gate electrode is arranged in the trench and electrically insulated from the semiconductor substate by a gate insulating layer. A field plate is arranged in the trench under the gate electrode. The field plate is electrically insulated from the gate electrode and from the semiconductor substrate by a field insulator. The base of the trench is positioned at a depth d form the first major surface, wherein 250 nm ≤ d ≤ 800 nm.

In some embodiments, 400 nm ≤ d ≤ 700 nm.

The transistor device can be considered to have a shallow trench as the maximum depth of the trench, in which the field plate and gate electrode is positioned, is 800 nm and can be as small as 250 nm. Transistor devices with such a shallow trench may have a lower breakdown voltage, e.g. less than 25V such as 15V, and a high efficiency.

In some embodiments, the transistor device further comprises a gate contact extending from the first major surface to the gate electrode, wherein the gate contact has a base positioned at a distance d_{g} from the first major surface and 50 nm ≤ d_{g} ≤ 200 nm, a field plate contact extending from the first major surface to the gate electrode, wherein the field plate contact has a base positioned at a distance d_{fp} from the first major surface and 300 nm ≤ d_{fp} ≤ 500 nm and a mesa contact extending from the first major surface to body region, wherein the mesa contact has a base positioned at a distance dₘ from the first major surface and 80 nm ≤ dₘ ≤ 350 nm, whereby d_{fp} > dₘ > d_{g}.

In some embodiments, the gate electrode has an upper surface and a lower surface and a maximum height h_{g} between the upper surface and the lower surface and the field plate has an upper surface and a lower surface and a maximum height h_{f} between the upper surface and the lower surface and the ratio of the heights, h_{g}/h_{f}, is 0.8 ≤ h_{g}/h_{f} ≤ 1.5.

In some embodiments, the base of the gate contact is positioned on or within the gate electrode between the upper and lower surface of the gate electrode and the base of the field plate is positioned on or within the field plate between the upper and lower surface of the field plate.

In some embodiments, the base of the gate contact is positioned at a distance from the upper surface of the gate electrode, d_{g_rel} which may lie in the range of 0 nm ≤ d_{g_rel} ≤ 35 nm so that the base of the gate contact is positioned on or within the gate electrode between the upper and lower surface of the gate electrode. In some embodiments, the base of the field plate contact is positioned at a distance from the upper surface of the field plate, d_{f_rel} which may lie in the range of 0 nm ≤ d_{f_rel} ≤ 35 nm so that the base of the field plate is positioned on or within the field plate between the upper and lower surface of the field plate.

In some embodiments, the trench in which the field plate and gate electrode is arranged may have an elongate stripe -like form having a length which extends parallel to the first major surface. The length of the trench is greater than its depth from the first major surface and which is in turn greater than its width. The field plate and the gate electrode also have an elongate stripe-like structure. having a length which extends parallel to the first major surface and which is greater than its depth from the first major surface, which is in turn greater than its width.

Typically, the transistor device comprises a plurality of trenches that expend substantially parallel to one another with a mesa being formed between the sidewalls of adjacent ones of the trenches. The mesa comprises the drift region, body region and source region. One trench with its gate electrode and field plate and one mesa form a transistor cell. Typically, the transistor device comprises a plurality of transistor cells that are electrically coupled in parallel.

In some embodiments, the gate electrode has a length that is less than the length of the field plate such that a portion of the field plate, typically at one end of the trench, is not covered by the gate electrode. In this portion of the trench, the electrically insulating material in the trench extends from the field plate to the first major surface. In some embodiments, the gate electrode is interrupted e.g. includes two or more sections that are spaced apart by a gap that is located intermediate the length of the trench. In this gap or gaps, the gate electrode does not cover the field plate so that the electrically insulating material in the trench extends to the first major surface of the semiconductor substrate. The field plate contact can be placed in the gap. At least one gate contact and at least one field plate contact may be arranged in a single trench.

The first conductivity type may be p-type and the second conductivity type n-type or vice versa. The source region and the drain region are highly doped and the drain region is more highly doped than the drift region which is lightly doped.

The transistor device may be a MOSFET device, for example a power MOSFET device.

In some embodiments, the vertical transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device but also an emitter of an insulator gate bipolar transistor (IGBT) device and an emitter of a Bipolar Junction Transistor (BJT) device, the term "drain" encompasses not only a drain of a MOSFET device but also a collector of an insulator gate bipolar transistor (IGBT) device and a collector of a BJT device, and the term "gate" encompasses not only a gate of a MOSFET device but also a gate of an insulator gate bipolar transistor (IGBT) device and a base of a BJT device.

The transistor device may further comprise a metallization structure arranged on the first major surface. The metallization structure comprises at least one conductive layer and optionally one or more further electrically insulating layers. The metallization structure comprises a conductive redistribution structure with a portion for the source regions and field plates and a separate portion for the gate electrodes. The metallization structure provides a source pad electrically connected to the source region and the field plates and a gate pad electrically connected to the gate electrodes. A drain pad is arranged on the opposing second surface of the semiconductor substrate that is electrically connected to the drain region.

The semiconductor substrate may be formed of silicon and may be formed of monocrystalline silicon or an epitaxially deposited silicon layer, also known as an epi layer, formed on a base substrate. The gate electrode and the field plate are electrically conductive and may be formed of polysilicon.

In an embodiment, a method of fabricating contacts to a semiconductor substrate is provided. The method comprises providing a semiconductor substrate having a first major surface and a second major surface opposing the first major surface, a trench arranged in the first surface comprising a base and sidewalls. A gate electrode is arranged in the trench, a field plate is arranged in the trench under the gate electrode and electrically insulating material is arranged in the trench and electrically insulates the gate electrode and the field plate from the semiconductor substate and from each other. A first electrically insulating layer is arranged on the first major surface of the semiconductor substrate and on the trench. The base of the trench is positioned at a depth d form the first major surface, wherein 250 nm ≤ d ≤ 800 nm. The method further comprises performing a first etch process and forming a first opening that extends through the first electrically insulating layer and the electrically insulating material in the trench to the gate electrode, forming a second opening that extends through the first electrically insulating layer and the electrically insulating material in the trench to the field plate and forming a third opening that is positioned laterally adjacent the trench and that extends through the first electrically insulating layer to the first major surface of the semiconductor substrate. A resist material is applied that covers the first and second openings and leaves the third opening exposed. A second etch process is then performed and the depth of the third opening is extended and a mesa contact opening is formed in the first major surface that extends into the semiconductor substrate. The resist material is then removed and conductive material inserted into the first opening, the second opening and the mesa contact opening, whereby a gate contact, a field plate contact and a mesa contact, respectively, are formed.

This method may be used to fabricate the transistor device according to any one of the embodiments described herein.

The trench in which the field plate and gate electrode is arranged may have an elongate stripe -like form having a length which extends parallel to the first major surface. The length of the trench is greater than its depth from the first major surface and which is in turn greater than its width. The field plate and the gate electrode also have an elongate stripe-like structure.

The second opening is positioned at a portion of the trench in which the gate electrode is absent. In some embodiments, the gate electrode has a length that is less than the length of the field plate such that a portion of the field plate, typically at one end of the trench, is not covered by the gate electrode. In this portion of the trench, the electrically insulating material in the trench extends from the field plate to the first major surface. In some embodiments, the gate electrode is interrupted e.g. includes two or more sections spaced apart by a gap that is located intermediate the length of the trench. In this gap, the gate electrode does not cover the field plate so that the electrically insulating material in the trench extends to the first major surface of the semiconductor substrate and the third opening can be placed in the gap so as to form a field plate contact of the field plate located in the lower portion of the trench. One or more of the first and second openings may be formed to a single trench.

Three different types of opening are formed in the first etch process. After the first etch process, the first and second opening each have substantially their final depth and the first and second opening are not subjected to the second etch process. The depth of the third opening is increased by performing the second etch process only on the third type of opening to form an opening for a contact to the mesa. After the second etch process, the base of the third opening may be positioned in the body region so that the third opening extends though the source region and into the body region.

This two-stage etch method may be used to assist in forming a good contact to the mesa without increasing the depth of the first opening for the gate contact and the second opening for the field plate contact. The two- stage etch process may assist in not overetching the first opening for the gate contact and the second opening for the field plate and is useful for devices including shallower trenches, i.e. a trench with a depth d of less than 1 µm, e.g. 250 nm ≤ d ≤ 800 nm. The depth d denotes the distance of the base of the trench from the first major surface of the semiconductor substrate.

A wet etch or a plasma etch may be used for the first and second etching processes. In some embodiments, a wet etching process Is used for both the first and second etch process.

The methods described herein may be used for fabricating a transistor device such as a power MOSFET. In some embodiments, the vertical transistor device is a MOSFET (Metal Oxide Semiconductor Field Effect Transistor) device, an insulated gate bipolar transistor (IGBT) device or a Bipolar Junction Transistor (BJT).

The electrodes or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device but also an emitter of an insulator gate bipolar transistor (IGBT) device and an emitter of a Bipolar Junction Transistor (BJT) device, the term "drain" encompasses not only a drain of a MOSFET device but also a collector of an insulator gate bipolar transistor (IGBT) device and a collector of a BJT device, and the term "gate" encompasses not only a gate of a MOSFET device but also a gate of an insulator gate bipolar transistor (IGBT) device and a base of a BJT device.

The semiconductor substrate may be formed of silicon and may be formed of monocrystalline silicon or an epitaxially deposited silicon layer, also known as an epi layer, formed on a base substrate. The gate electrode and the field plate are electrically conductive and may be formed of polysilicon.

In some embodiments, the method further comprises, before applying the resist material, forming a second electrically insulating layer on sidewalls and a base of each of the first, second and third openings and on an upper surface of the first electrically insulating layer that is arranged on the first major surface of the semiconductor substrate. The second electrically insulating layer may be conformal.

In some embodiments, during the second etch process, the second electrically insulating layer is removed from the regions of the upper surface of the first electrically insulating layer that are exposed from the resist material and from the base of the third opening and at least a part may remain on the side walls of the third opening formed in the first electrically insulating layer.

In some embodiments, the method further comprises after removing the resist material, entirely removing the second electrically insulating layer.

In some embodiments, an upper portion of the first electrically insulating layer is removed in the second etch process. This reduces the thickness of the first insulating layer that is exposed from the resist material.

In some embodiments, a planarization process may be carried out so that a planar upper surface is formed for the first electrically insulating layer. A metallization structure can be formed on this planar surface. The metallization structure may comprise at least one conductive layer and optionally one or more further electrically insulating layers. The metallization structure comprises a conductive redistribution structure with a portion for the source regions and field plates and a separate portion for the gate electrodes. The metallization structure provides a source pad electrically connected to the source region and the field plates and a gate pad electrically connected to the gate electrodes. A drain pad is arranged on the opposing second surface of the semiconductor substrate that is electrically connected to the drain region.

In some embodiments, the method further comprises, after removing the resist material, implanting dopants into the base of each of the first opening, the second opening and the mesa contact opening and then entirely removing the second electrically insulating layer. The dopants may be used to form a highly doped contact region at the base of the respective opening so as to reduce the contact resistance.

In some embodiments, the inserting the conductive material comprises forming at least one barrier layer on the side walls and the base of each of the first opening, the second opening and the mesa contact opening and on the upper surface of the first electrically insulating layer and forming one or more conductive layers on the at least one barrier layer.

In some embodiments, the field plate has a length that is greater than the length of the gate electrode so that in at least one region of the trench, the field plate is uncovered by the gate electrode. The second opening is arranged in this region.

In some embodiments, the semiconductor substrate comprises a drain region of a first conductivity type formed at the second surface, a drift region of the first conductivity formed on the drain region, a body region of a second conductivity type that opposes the first conductivity type formed on the drift region and a source region of a first conductivity type formed on and/or in the body region and the base of the mesa contact opening is arranged in the body region.

In some embodiments, the gate contact has a base positioned at a distance d_{g} from the first major surface and 30 nm ≤ d_{g} ≤ 200 nm, the field plate contact has a base positioned at a distance d_{fp} from the first major surface and 300 nm ≤ d_{fp} ≤ 500 nm and the mesa contact has a base positioned at a distance dₘ from the first major surface and 80 nm ≤ dₘ ≤ 350 nm, wherein d_{fp} > dₘ > d_{g}.

In some embodiments, the base of the gate contact is positioned at a distance from the upper surface of the gate electrode, d_{g_rel} which may lie in the range of 0 nm ≤ d_{g_rel} ≤ 35 nm so that the base of the gate contact is positioned on or within the gate electrode between the upper and lower surface of the gate electrode. In some embodiments, the base of the field plate contact is positioned at a distance from the upper surface of the field plate, d_{f_rel} which may lie in the range of 0 nm ≤ d_{f_rel} ≤ 35 nm so that the base of the field plate is positioned on or within the field plate between the upper and lower surface of the field plate.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-section view of a transistor device according to an embodiment.
Figure 2, which includes figures 2A to 2G, illustrates a method of forming contacts to a semiconductor substrate.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

For some applications, including low voltage applications, it is desirable to have a power MOSFET with a high density, high frequency and high efficiency. This may be provided by a power MOSFET having a lower breakdown voltage which in turn can be provided by a trench-based charge compensation transistor having a shallower trench depth, for example a trench depth around from 500nm to 700nm. A shallow trench of less than 700nm, e.g. 500 nm to 700 nm, could be used for a power MOSFET with a lower breakdown voltage of, for example 15V power MOSFET.

One practical issue that is considered herein for shallower trench devices is the control of the gate contact groove depth so as to mitigate or even eliminate the risk of the contact penetrating through the gate electrode and even into the underlying field plate in the shallower trench while keeping same contact depth for the contact to the semiconductor, i.e. the mesa contact, as the channel length does not change as a result of the shallower trench for the field plate and gate electrode. If the gate contact would penetrate through the gate electrode and possibly into or through the underlying field plate, the desired parameters of the device, e.g. IGSS, IDSS may not be provided. Increased leakage between gate electrode and field plate may generate induced turn on and Igss fail. Due to the shallower trench, the thickness of the electrically insulating material surrounding the field plate may be reduced. If the contact to the field plate extends through the field plate, this may cause a short circuit from source to drain and cause an IDSS failure.

To avoid these issues, it is proposed to block the groove etch in gate and field plate area while keeping the same groove contact in the mesa area of the transistor device. To achieve this, an additional lithography mask may be introduced to block the groove contact etch to the gate electrode and field plate while allowing the mesa groove etch to keep the same behavior so that the mesa contact has same depth. As transistor devices having a similar structure but with a deeper trench, for example a trench of at least 1 µm. This enables the channel length to be retained or be similar.

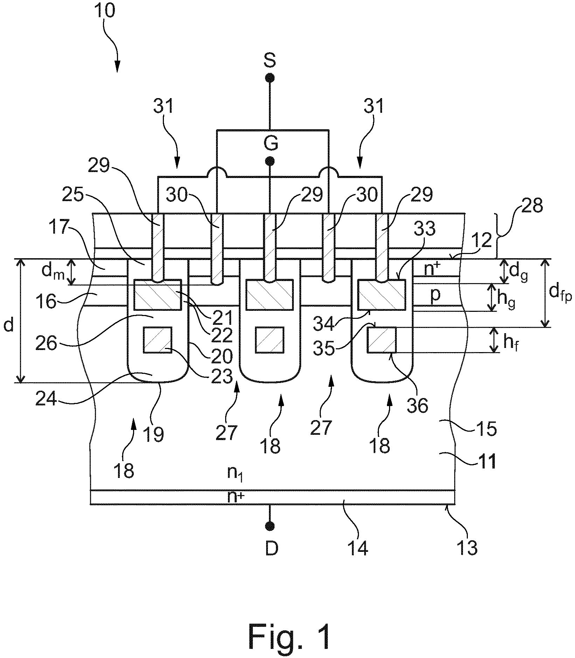

Figure 1 illustrates a cross-sectional view of a transistor device 10 which comprises a semiconductor substrate 11 comprising a first major surface 12 and a second major surface 13 opposing the first major surface 12. A drain region 14 of the first conductivity type is arranged at or near the second major surface 13, a drift region 15 of the first conductivity type is arranged on the drain region 14, a body region 16 of the second conductivity type that opposes the first conductivity type is arranged on the drift region 15 and a source region 17 of the first conductivity type is arranged on and/or in the body region 16. The first conductivity type may be n-type and the second conductivity type p-type or vice versa. The drain region 14 and source region 17 may be highly doped and the drift region lightly doped with the first conductivity type.

The semiconductor substrate 11 may be formed of silicon and may be formed of monocrystalline silicon or an epitaxially deposited silicon layer, also known as an epi layer, formed on a base substrate.

The transistor device 10 comprises a trench 18 which is arranged in the first major surface 12 and which has a base 19 and sidewalls 20 which extend from the base 19 to the first major surface 12. The trench 19 has a maximum depth, d, from the first major surface 12, whereby d lies between 250 nm and 800 nm. In some embodiments, the maximum depth of the trench 18 from the first major surface 12 lies within a range of 400 nm to 700 nm.

Each of the trenches 18 has an elongate stripe -like structure having a length, which extends into the plane of the drawing, which is greater than its depth, d, from the first major surface 12 and its width. The side walls 20 may extend substantially perpendicularly to the first major surface 12 of the semiconductor substrate 11 and to the base 19 of the trench 18. The side walls 20 may also extend substantially perpendicularly to one another to from a rectangular shape in the view. The transistor device 10 comprises a plurality of trenches 18 which extend substantially parallel to one another such that a mesa 27 is formed between adjacent ones of the trenches 18. Each mesa 27 comprises the drift region 15, body region 16 and source region 17.

A gate electrode 21 is arranged in the trench 18. The gate electrode 21 is elongate and has a stipe-like form with a length that extends along the majority of the length of the trench 18. The gate electrode 21 is electrically conductive and is electrically insulated from the semiconductor substrate 11 by a gate insulating layer 22. The gate insulating layer 22 is arranged on the sidewalls 20 of the trench 18. A field plate 23 is also arranged in the trench 18 and is located under and spaced apart from the gate electrode 21 which is positioned in the upper part of the trench 18. The field plate 23 is elongate and has a stipe-like form with a length that extends along the majority of the length of the trench 18. The field plate 23 is electrically conductive and is electrically insulated from the gate electrode 21 and the semiconductor substrate 11 by a field insulator 24. The field insulator 24 is arranged on the base 19 and on the sidewalls 20 of the trench 18. The field insulator 24 on the sidewalls 20 has a greater thickness than the thickness of the gate insulating layer 22 on the sidewalls 20. An intermediate electrically insulating layer insulator 26 is arranged in the gap between the upper surface 35 of the field plate 23 and the lower surface 34 of the gate electrode 21. The upper surface 33 of the gate electrode 21 is arranged within the trench 18 and below the first major surface 12. An upper electrically insulating layer 25 is arranged on the upper surface 33 of the gate electrode 21 and fills the space in the trench between the upper surface 33 of the gate electrode 21 and the first major surface 12 of the semiconductor substrate 11.

The field plate 23 and the gate electrode 21 may be formed of polysilicon and the gate insulating layer 22, the field insulator 24, the intermediate electrically insulating layer 26 and the upper electrically insulating layer 25 may be formed of silicon oxide which may be silicon dioxide SiO₂ or SiOₓ, for example.

The transistor device 10 comprises a plurality of transistor cells 31 which are electrically coupled in parallel so as to be able to switch a load current. Each transistor cell 31 comprises one of the trenches 18 with the gate electrode 21 and field plate 23 and one of the mesas 27. The transistor device 10 further comprises one or more electrically insulating layers 28 which are arranged on the first major surface 12 of the semiconductor substrate 11 and which extend over the mesas 27 and trenches 18.

The gate electrode 21 arranged in each of trenches 18 is electrically contacted by means of a gate contact 29 which extends through the electrically insulating layer 28 arranged on the first major surface 12 and through the electrically insulating layer 25 which is arranged in the uppermost part of the trench 18. The gate contact 29 has a base which is in contact with and which may be positioned within the height of the gate electrode 21. The distance between the upper surface 33 of the gate electrode 21 and the base of the gate contact 29 may be between 0 nm and 35 nm. This distance is the overlap between the gate contact 29 and the material of the gate electrode 21. The individual gate contacts 29 are electrically connected to one another by a conductive gate redistribution structure of a non-illustrated metallisation structure which is arranged on the electrically insulating layer 28.

A second type of contact is made to the field plate 23 which is positioned in a plane of the transistor device10 which is behind or in front of the plane of the drawing and which cannot be seen in the cross-sectional view of figure 1. The second type of contact is positioned in a portion of the trench 18 which is free of the gate electrode 21. For example, the gate electrode 21 may have a length which is shorter than the length of field plate 23 such that a portion of the field plate 23, typically arranged at an end of the trench 18, is uncovered by the gate electrode 21. In this portion of the field plate 23 that is uncovered by the gate electrode 21, the electrically insulating material 25 extends fills the upper portion of the trench and extends from the upper surface of the field plate 23 to the first major surface 12 of the semiconductor substrate 11. The field plate contact also extends through the electrically insulating layer 28 through the electric insulating material 25 arranged in the trench 18 and has a base which is positioned on or in the field plate 23. The distance between the upper surface 35 of the field plate 23 and the base of the field plate contact may be between 0 nm and 35 nm. This distance is the overlap between the field plate contact and the material of the field plate 23.

A third type of contact 30 is formed to each mesa 27. The mesa contact 30 extends through the electrically insulating layer 28 and into the semiconductor substrate 11 such that the mesa contact 30 has a base which is positioned within the body region 16. The mesa contact 30 is also electrically connected to the source region 17. The individual ones of the contacts 30 are electrically connected together by a source redistribution structure of the metallisation structure. The plurality of field plate contacts are also electrically connected to the source redistribution structure of the metallisation structure.

As mentioned above, the trench 18 has a depth d which lies with the range of 250 nm to 800 nm. The trench 18 may be referred to as a shallow trench, since trench-based compensation transistor devices traditionally have deeper trenches which have a depth of at least 1 µm. The gate electrode 21 has a maximum height h_{g} between its upper surface 33 and lower surface 34 and the field plate has a maximum height h_{f} between its upper surface 35 and its lower surface 36.

Since the trench 18 has a depth which is less than the depth of a typical transistor device with a deeper trench, the height h_{f} of the field plate 23 may be reduced compared to that of a typical transistor device with a deeper trench so as to accommodate both the gate electrode 21 and the field plate 23 within the shallower trench 18. The height h_{g} of the gate electrode 21 may be substantially the same as the corresponding typical transistor device with a deeper trench in order that the channel length of the transistor device 10 remains substantially the same. The ratio of the height of the gate electrode 21 to the height of the field plate 23, hg/hf, lies within the range of 0.8 and 1.5. This ratio is larger than that for transistor devices having deeper trenches which have a field plate of a greater height.

The gate contact 29 has a base positioned at a distance d_{g} from the first major surface and 30 nm ≤ d_{g} ≤ 200 nm. The field plate contact extends from the first major surface to the field plate and has a base positioned at a distance d_{fp} from the first major surface 12 and 300 nm ≤ d_{fp} ≤ 500 nm. The mesa contact 30 extends from the first major surface 12 to the body region 16 and has a base positioned at a distance dₘ from the first major surface 12, whereby 80 nm ≤ dₘ ≤ 350 nm. The depth of the base of the field plate contact measured from the first major surface 12 is greater than the depth of the base of the mesa contact 30 from the first major surface 12 which is in turn greater than the depth of the base of the gate contact 29 from the first major surface 12 so that d_{fp} > dₘ > d_{g}.

It is desirable that the lower surface of the gate contact 29 is located at a depth d_{g} from the first major surface 12 which lies within the height of the gate electrode 21 and which does not extend into the intermediate electrically insulating material 26 which is positioned between the lower surface 34 of the gate electrode 21 and the upper surface 35 of the field plate 23 in order to avoid leakage and detrimental performance of the device. It is also desirable that the position of the lower surface of the gate contact 29 within the trenches 18 is well controllable. Similarly, it is desirable that the lower surface of the field plate contact is positioned within the height h_{f} of the field plate 23 and does not extend through the field plate 23 into the field insulator 24 arranged between the lower surface 36 of the field plate 23 and the base 19 of the trench 18 and even to touch the base 19 of the trench 18. At the same time, the position of the lower surface of the mesa contact 30 within the mesa 27 should be controllable in order to provide reliable contact to the body region 16 and source region 17 of the transistor device 10.

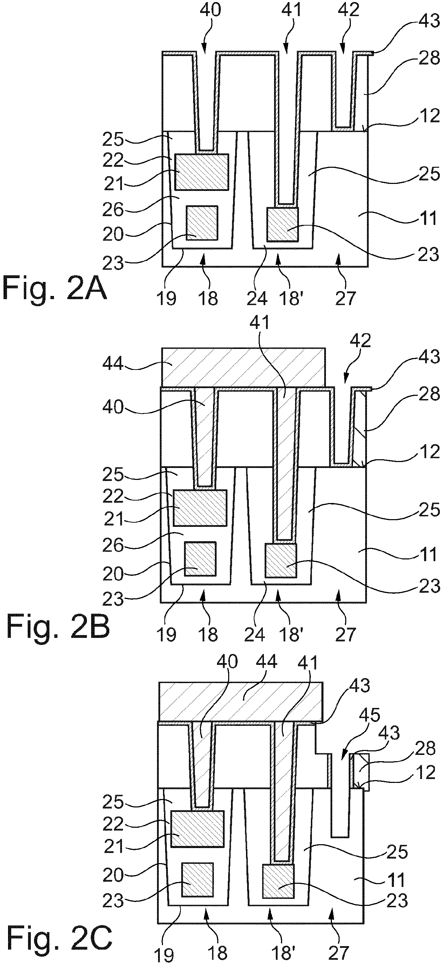

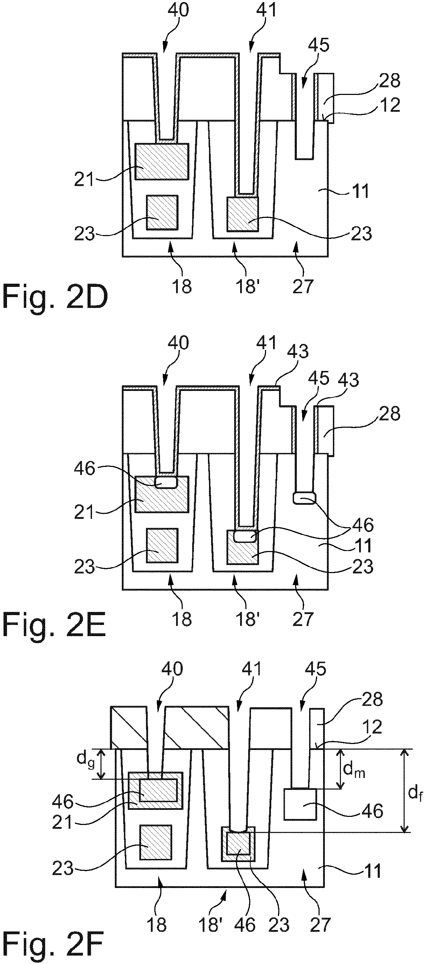

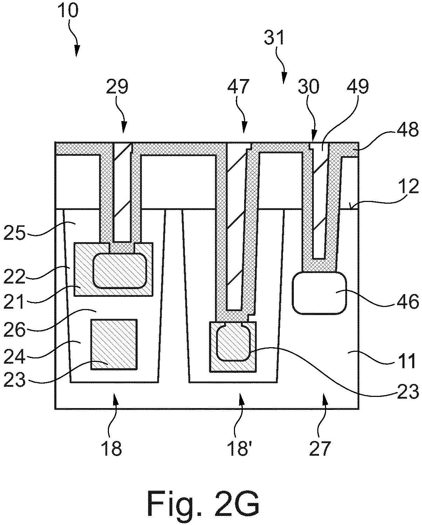

A method for achieving these aims will now be described with reference to figure 2, which includes figures 2A to 2G. In figure 2, the drain region 14, drift region 15, body region 16 and source region 17 are not shown. However, these regions are present in the semiconductor substrate 11.

Figure 2 illustrates a view of the semiconductor substrate 11 and illustrates a cross-sectional view of two of the trenches 18, 18'. In the illustrated cross-sectional view, the trench 18 comprises a field plate 23 arranged towards the bottom of the trench 18 and the gate electrode 21 arranged towards the top of the trench. In the illustrated cross-sectional view, the trench 18' includes only a field plate 23 arranged towards the bottom of the trench 18 so that the electrically insulating material 25 extends from the upper surface 35 of the field plate 23 to the first major surface 12. In other portions of the length of the trench 18', the gate electrode 21 is arranged above the field plate 23 so that in these regions, the trench 18' has a cross-section corresponding to that shown in figure 2 for the trench 18. The trench 18 also has a portion that lies outside of the plane of the drawing that has a structure without a field plate and has a cross-section that corresponds to that illustrated for the trench 18' in figure 2. The cross-sections shown for the trenches 18, 18' in figure 2 are present for each of the trenches 18 of the transistor device 10.

The cross-sectional views of figure 2 also show a mesa 27 which includes the drift region 15, body region 16 and source region 17 but which are not shown in figure 2. An electrically insulating layer 28 is formed on the first major surface 12. The electrically insulating layer may be formed of BPSG (Borophosphosilicate glass). The electrically insulating layer 28 may include two or more sublayers, for example USG (Undoped silicon glass) and BPSG.

Referring to figure 2A, a first etch process is carried out to form, for each transistor cell 31, first, second and third openings 40, 41, 42. The first etch process may be a wet etching process. The first opening 40 extends through the first insulating layer 28 located on the first major surface and through the electrically insulating material 25 arranged on the upper portion of the trench 18 and has a base which is in contact with the material of the gate electrode 21. The second opening extends through the first insulating layer 28 located on the first major surface 12 of the semiconductor substrate 11 and through the electrically insulating material 25 and has a base which is in contact with the field plate 23 in the lower portion of the trench 18. The third opening 42 extends through the first insulating layer 28 and has a base which is formed by a region of the first major surface 12.

The first etch process may be carried out by forming a mask on the upper surface of the first insulating layer 28 which has openings corresponding to the lateral arrangement of the first, second and third openings 40, 41, 42. The first etch process is carried out to remove the exposed regions of the first insulating layer 28 and insulating material 25 so as to form the first second and third openings 40, 41, 42. The first second and third openings 40, 41, 42 may also be referred to as contact holes or contact grooves as the openings are typically elongate.

After this first etch process, the second opening 41 for the field plate has a greater depth than the first opening 40 for the gate contact which has a greater depth than the third opening 42 for the mesa contact. This arrangement may be formed due to the different etchability, or etching rate, of the materials. For example, the electrically insulating material 25 within the trenches 18 may be, for example silicon dioxide, and may be more electable, that is removed at a faster rate, than the material of the gate electrode 21 and the field plate 23, which is for example polysilicon. Consequently, as the exposed material is removed by etching, when the first opening 40 has a base in which the material of the gate electrode is revealed, in the first opening 40 the material of the gate electrode 21 acts as an etch stop. The same first etching process continues to remove the electrically insulating material 25 revealed at the base of the second opening 41 until the material of the field plate 23 is revealed which then acts as an etch stop. The semiconductor substrate 11 is formed from material, typically silicon, which is removed at a slower rate in the first etching process than the electrically insulating material 25. When the semiconductor substrate 11 is revealed at the base of the third opening 42, the semiconductor substrate 11 acts as an etch stop whilst removal of the electrically insulating material 25 in revealed in the first and second openings 40, 41 continues.

After the first etching process, the second opening 41 has the greatest depth from the first major surface 12 of the semiconductor substrate 11, the first opening 40 has a depth that is less than that of the second opening 41 and the third opening 42 may not extend into the semiconductor substrate 11 at all or has a depth from the first major surface 12 that is less than the first opening 40.

It is desirable that the contact to the mesa 27 has a base positioned within the semiconductor substrate 11. In principle, it might be possible to increase the depth of the third opening 42 by increasing the length and/or changing the conditions of the first etch process. However, in this case, the depth of the first and second openings 40, 41 would be increased at the same time, which may be undesirable if the one or both of the openings 40, 41 extends too far into, and even completely through, one or both of the gate electrode 21 and the field plate 23.

This risk can be avoided by carrying out a second etch process and described with reference to figures 2B to 2G. After formation of the first, second and third openings 40, 41, 42 using the first etch process, an optional second insulating layer 43 is formed which covers the surfaces of the openings 40, 41, 42 and the upper surface of the first insulating layer 28. The second insulating layer may be formed using a TEOS (Tetra Ethyl Ortho Silicate) process.

Referring to figure 2B, a resist material 44 is formed on the over the first insulating layer 28 which covers the first and second openings 40, 41 but which leaves the third opening 42 exposed. Referring to figure 2C, a second etch process is carried out which increases the depth of the third opening 42 such that the base of the opening is positioned within the semiconductor substrate 11 at a distance from the first major surface 12 and a mesa contact opening 45 is formed. The base of the mesa contact opening 45 may be positioned within the body region. The second etch process may be a wet etch process or a plasma etch process.

During this second etch process, the exposed portion of the second insulating layer 43 may be removed entirely and an upper portion of the first insulating layer 28 may be removed. The thickness of the second insulating layer 43 arranged on the side walls of the remaining lower portion of the third opening 42 may be reduced. The second insulating layer 43 may even be entirely removed from the sidewalls of the third opening.

Referring to figure 2D, the resist material 44 then removed. In some embodiments, an optional implantation process may be carried out as shown in figure 2E in which dopants are implanted through the base of third opening 42 and optionally also the first and second openings 40, 41 to form a highly doped contact region 46 at the base of each the first and second openings 40, 41 and the mesa contact opening 45. An ashing and annealing process may then be carried out to remove the second insulating layer 43 entirely. After removal of the second insulating layer 43, a planarization process may be carried out to provide a planar surface formed of the material of the first insulating layer 28.

Referring to figure 2F, the semiconductor substrate 11 is then produced which has an opening 40 for the gate contact which has a depth d_{g} from the first major surface 12, mesa contact opening 45 having the depth dₘ from the first major surface 12 and the field plate opening 41 with a depth d_{fp} from the first major surface 12. In contrast to the relative depths after the first etch process shown in figure 2B, the mesa contact opening 45 is deeper than the gate contact opening 40 so that d_{fp} > dₘ > d_{g}.

Referring to figure 2G, conductive material is then inserted into the first opening 40, the second opening 41 the mesa contact opening 45 to form to form a gate contact 29, a field plate contact 47 and a mesa contact 30. In some embodiments, one or more barrier layers 48 may be formed which lines the openings 40, 41, 45 and which extends over the planarized surface of the electrically insulating layer 28. A barrier structure of Ti/TiN may be used. A second conductive material 49 may then be deposited which fills the openings 40, 41, 45 to form the gate contact 29 and the field plate contact 47 for one trench 18 and the mesa contact 30 for each transistor cell 31. The conductive material 49 may be tungsten for example.

A metallisation structure, which typically includes one or more conductive layers and insulating layers may be formed on the planarized surface of the first insulating layer 28. The metallization structure may comprise an electrically conductive redistribution structure for the mesa contacts 47 and field plate contacts 30 to connect them to one another and to a source pad and an electrically conductive redistribution structure for the gate contacts 29 so as to electrically connect the gate contacts 29 to one another and a gate pad. A drain pad is arranged on the opposing second surface of the semiconductor substrate that is electrically connected to the drain region.

This method may be used for fabricating a vertical MOSFET device with a trench having a depth of 250 nm to 800 nm, or 400 nm to 700 nm, whereby a field plate and a gate electrode are arranged in the trench and electrically insulated from the semiconductor substrate and from one another. This vertical MOSFET device has a stable threshold voltage, which may be less than 25V, good avalanche behaviour and reduced gate to source leakage whilst avoid shorting between drain and source.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. Method of fabricating contacts to a semiconductor substrate, the method comprising:
providing a semiconductor substrate having, a first major surface and a second major surface opposing the first major surface, a trench formed in the first surface comprising a base and sidewalls, a gate electrode that is formed in the trench, a field plate formed in the trench under the gate electrode and electrically insulating material arranged in the trench and electrically insulating the gate electrode and the field plate from the semiconductor substate and from each other; a first electrically insulating layer arranged on the first major surface and on the trench, wherein the base of the trench is positioned at a depth d form the first major surface, wherein 250 nm ≤ d ≤ 800 nm;
performing a first etch process and
forming a first opening in the that extends through the first electrically insulating layer and the electrically insulating material in the trench to the gate electrode,
forming a second opening that extends through the first electrically insulating layer and the electrically insulating material in the trench to the field plate, wherein the second opening is positioned at a portion of the trench in which the gate electrode is absent, and
forming a third opening that is positioned laterally adjacent the trench and that extends through the first electrically insulating layer to the first major surface of the semiconductor substrate;
applying a resist material that covers the first and second openings and leaves the third opening exposed,
performing a second etch process and extending the depth of the third opening and forming a mesa contact opening in the first major surface that extends into the semiconductor substrate;
removing the resist material;
inserting conductive material into the first opening, the second opening and the mesa contact opening and forming a gate contact, a field plate contact and a mesa contact, respectively.

2. A method according to claim 1, further comprising: before applying the resist material, forming a second electrically insulating layer on sidewalls and a base of each of the first, second and third openings and on an upper surface of the first electrically insulating layer.

3. A method according to claim 2, wherein during the second etch process the second electrically insulating layer is removed from the upper surface of the first electrically insulating layer and from the base of the third opening and remains at least in part on the side walls of the third opening in the first electrically insulating layer,

4. A method according to claim 2 or claim 3, further comprising after removing the resist material, entirely removing the second electrically insulating layer.

5. A method according to any one of claims 1 to 4, wherein an upper portion of the first electrically insulating layer is removed in the second etch process.

6. A method according to any one of claims 1 to 5, further comprising, after removing the resist material, implanting dopants into the base of each of the first opening, the second opening and the mesa contact opening and then entirely removing the second electrically insulating layer.

7. A method according to any one of claims 1 to 6, wherein the inserting the conductive material comprises:
forming at least one barrier layer on the side walls and the base of each of the first opening, the second opening and the mesa contact opening and on the upper surface of the first electrically insulating layer, and
forming a conductive layer on the at least one barrier layer.

8. A method according to any one of claims 1 to 7, wherein the field plate has a length that is greater than the length of the gate electrode so that in at least one region of the trench, the field plate is uncovered by the gate electrode and the second opening is arranged in this region.

9. A method according to any one of claims 1 to 8, wherein the semiconductor substrate comprises a drain region of a first conductivity type formed at the second surface, a drift region of the first conductivity formed on the drain region, a body region of a second conductivity type that opposes the first conductivity type formed on the drift region and a source region of a first conductivity type formed on and/or in the body region and the base of the mesa contact opening is arranged in the body region.

10. A method according to any one of claims 1 to 9, wherein the gate contact has a base positioned at a distance d_{g} from the first major surface and 30 nm ≤ d_{g} ≤ 200 nm, the field plate contact has a base positioned at a distance d_{fp} from the first major surface and 300 nm ≤ d_{fp} ≤ 500 nm and the mesa contact has a base positioned at a distance dₘ from the first major surface and 80 nm ≤ dₘ ≤ 350 nm, wherein d_{fp} > dₘ > d_{g}.

11. A transistor device, comprising:
a semiconductor substrate having a first major surface and a second major surface opposing the first major surface;
a drain region of a first conductivity type formed at the second surface, a drift region of the first conductivity formed on the drain region, a body region of a second conductivity type that opposes the first conductivity type formed on the drift region and a source region of a first conductivity type formed on and/or in the body region;
a trench arranged in the first surface comprising a base and sidewalls;
a gate electrode arranged in the trench and electrically insulated from the semiconductor substate by a gate insulating layer;
a field plate arranged in the trench under the gate electrode and electrically insulated from the gate electrode and the semiconductor substrate by a field insulator;
wherein the base of the trench is positioned at a depth d form the first major surface, wherein 250 nm ≤ d ≤ 800 nm.

12. A transistor device according to claim 11, wherein 400 nm ≤ d ≤ 700 nm.

13. A transistor device according to claim 11 or claim 12, further comprising:
a gate contact extending from the first major surface to the gate electrode, wherein the gate contact has a base positioned at a distance d_{g} from the first major surface and 30 nm ≤ d_{g} ≤ 200 nm;
a field plate contact extending from the first major surface to the gate electrode, wherein the field plate contact has a base positioned at a distance d_{fp} from the first major surface and 300 nm ≤ d_{fp} ≤ 500 nm;
a mesa contact extending from the first major surface to body region, wherein the mesa contact has a base positioned at a distance dₘ from the first major surface and 80 nm ≤ dₘ ≤ 350 nm,
wherein d_{fp} > dₘ > d_{g}.

14. A transistor device according to claim 13, wherein the base of the gate contact is positioned on or in the gate electrode and the base of the field plate is positioned on or in the field plate.

15. A transistor device according to any one of claims 11 to 14, wherein
the gate electrode has a maximum height h_{g} between an upper surface and a lower surface and the field plate has a maximum height h_{f} between an upper surface and a lower surface and 0.8 ≤ h_{g}/h_{f} ≤ 1.5, and/or
the base of the gate contact is positioned at a distance from the upper surface of the gate electrode, d_{g_rel}, wherein 0 nm ≤ d_{g_rel} ≤ 35 nm, and/or
the base of the field plate contact is positioned at a distance from the upper surface of the field plate, d_{f_rel}, wherein 0 nm ≤ d_{f_rel} ≤ 35 nm.
